**Europäisches Patentamt**

**European Patent Office**

**Office européen des brevets**

(11) Publication number: **0 095 847**
**B1**

(12) **EUROPEAN PATENT SPECIFICATION**

(45) Date of publication of patent specification: **28.11.90**

(51) Int. Cl.⁵: **G 11 C 17/12**

(21) Application number: **83302747.7**

(22) Date of filing: **16.05.83**

(54) Compact ROM with reduced access time.

(30) Priority: **01.06.82 US 383709**

(43) Date of publication of application:
**07.12.83 Bulletin 83/49**

(45) Publication of the grant of the patent:
**28.11.90 Bulletin 90/48**

(84) Designated Contracting States:
**CH DE FR GB IT LI NL**

(56) References cited:
**JP-A-53 125 787**
**US-A-4 183 093**
**US-A-4 274 147**

**PATENTS ABSTRACTS OF JAPAN, volume 3,
no. 153(E-159) December 15, 1979, page 15-E-
159, & JP - A - 54 132 140 (NIPPON DENKI)**

(73) Proprietor: **GENERAL INSTRUMENT
CORPORATION
225 Allwood Road
Clifton, N.J. 07012 (US)**

(72) Inventor: **Naiff, Kenneth I.
29 Harding Street Hauppauge
Long Island N.Y. 11787 (US)**

(74) Representative: **Allam, Peter Clerk et al
LLOYD WISE, TREGEAR & CO. Norman House
105-109 Strand
London WC2R 0AE (GB)**

## Description

The present invention relates to read only memories (ROMs) and, more particularly, to a serial stack or column read only memory using FET memory elements.

A read only memory is an electronic information storage device. Unlike erasable memories, a read only memory is fabricated to contain information which is defined by the structure of the memory and, thus, the information therein cannot be altered. Such a memory has the advantage of retaining the stored information therein without the necessity of periodic refreshing. In the event of a power disruption, the information contained in the memory is therefore not lost.

As with other types of electronic memories, it is desirable to fabricate a read only memory to maximize the amount of information which can be stored on a given area on a chip. Thus, fabrication techniques have been developed to increase the number of memory units per given area and enhance the density of the memory.

For example, silicon gate technology utilizing a self-aligned gate structure has reduced the space required on the chip by about 20%—30%, as compared with memories employing aluminum gate metal oxide semiconductor transistors. For this reason, read only memories employing silicon gate fabrication techniques are currently widely used.

In the *I.E.E.E. Journal of Solid-State Circuits* of June 1976, Hiroto Kawagoe and Nobuhiro Tsuji published an article entitled "Minimum Size ROM Structure Compatible With Silicon-Gate E/D MOS LSI", in which a new read only memory structure was disclosed. In the new structure, a cascade ratioless circuit configuration is used. The content of a memory cell is determined by the choice of the transistor threshold mode, that is, either enhancement or depletion, as contrasted to the conventional read only memory structure where the content of a memory cell is distinguished by the existence or absence of an operable transistor. The authors claim that this fabrication technique can reduce the size of the read only memory by 45%, as compared to conventional silicon gate read only memories.

The conventional read only memory consists of a plurality of flip-flop circuits, address decoders, and a matrix array of memory units. The flip-flop circuits are utilized to hold an address in the memory unit matrix with a binary code. The address decoders are utilized to select the row and column of the particular memory unit which is to be read.

Each of the conventional-type memory columns consists of a plurality of memory units which are connected in parallel. The state of each memory unit is distinguished by the existence or absence of an operable transistor. If P channel metal oxide semiconductor transistors are used, the signal read-out is performed by applying a low level signal (near the negative power supply voltage) to the selected address line. A high level signal (nearly zero volts) is applied to all of the non-selected address lines.

If the selected transistor is non-operable, that is, has a thick gate oxide, the application of the low level signal to the control terminal thereof will not render the transistor conductive and, thus, a precharged output node will not be discharged. On the other hand, if a functioning transistor has been selected, that is, one with a thin gate oxide, the application of the address signal to the control terminal thereof will render the transistor conductive, thereby discharging the pre-charged output node. Thus, whether the output node is discharged or not indicates whether an operable transistor existed at the addressed location.

The Kawagoe/Tsuji read only memory structure disclosed in the article uses both enhancement mode and depletion mode transistors for the memory units. Design and fabrication are simplified because no through holes are required. The size of a single bit of the memory is substantially reduced and the necessity for an aluminum layer in the matrix is eliminated.

The Kawagoe/Tsuji read only memory uses a cascade ratioless circuit configuration which consists of enhancement mode and depletion mode silicon gate semiconductor transistors, connected in series as driver elements to form a stack, instead of the conventional parallel configuration. The depletion mode transistors act as resistors between the enhancement mode transistors. The mode of the transistor, that is, whether same is enhancement or depletion, is selected in accordance with the information to be defined at the location of the particular transistor. Because of this arrangement, the structure of the chip is significantly simplified and, thus, the size of the random access memory is greatly reduced.

While the read only memory structure proposed by Kawagoe and Tsuji is a significant improvement over the conventional silicon gate read only memory, it has a significant drawback. In order to obtain a memory of reasonable size, each stack must be relatively long. The large number of series connected driver transistors form a circuit with a relatively high impedance. When this high impedance circuit is connected directly to a high capacitive load, as it is in the Kawagoe/Tsuji read only memory, a relatively high discharge time results. In the example in the article, each stack comprises 48 silicon gate semiconductor driver transistors connected in series. This circuit is directly connected to drive a load of approximately 1.5 pF, resulting in a delay time of approximately 2 microseconds.

In view of this, it can be readily appreciated that there is a direct relationship in the Kawagoe/Tsuji memory between the number of series connected transistors in the stack and the memory delay time. As the number of transistors in the stack increases, so does the delay time. Thus, it would be a significant achievement if this relationship could be circumvented because larger memories would result with no sacrifice in response time.

This relationship can be circumvented through the use of an isolation transistor, interposed between the series connected driver transistors and the output node. The control node of the isolation transistor is connected to the series connected drivers. The output circuit is connected between ground and the output node. The output node is connected through a load to a source.

Prior to addressing, the control node of the isolation transistor is precharged to render the isolation transistor conductive. If all of the transistors in the stack are rendered conductive when addressed, the control node of the isolation transistor is grounded through the drivers, thereby dissipating the precharge, the isolation transistor is rendered non-conductive and the output node remains charged. Otherwise, the isolation transistor remains conductive and the output node is rapidly discharged to ground through the output circuit of the isolation transistor.

With this system, the time it takes for the output node to discharge is a function of the size of the isolation transistor. In order to obtain a short discharge time, the isolation transistor must be relatively large. However, the isolation transistor cannot be too large because the larger the isolation transistor, the greater the capacitance of the output circuit and, hence, the higher the discharge time.

With the size of the isolation transistor selected for maximum speed, it becomes evident that the isolation transistor is too large to permit maximum circuit density if one isolation transistor is provided for each stack. It is preferable, therefore, to design the circuit such that the driver transistor concentration is enhanced by utilizing a single isolation transistor for multiple columns of series connected driver transistors.

This is accomplished by interposing selection transistors between the isolation transistor and multiple columns or stacks. These transistors select, in accordance with selection signals, a single one of the stacks for connection to the isolation transistor. In this manner, both high speed and high density are achieved simultaneously.

One ROM circuit arrangement incorporating an isolation transistor common to a plurality of columns is disclosed in Japanese Patent Laid-Open No. 1257787/1978 (NEC Corporation). This ROM circuit arrangement is an example of the general kind in which binary bit values are stored by FET memory elements of a first or second type in accord with the bit value stored thereby, the memory elements being arranged in an addressable matrix of rows and columns, the memory elements of each column being serially-connected to provide a selectable current path between first and second circuit nodes, and comprising column selection means connected between said columns and said first circuit node to perform the column addressing of an addressed memory element, the conductivity of the current path through the selected column being determined by which type the addressed memory element is, and readout means responsive to the conductivity of the current path through the selected column to provide a signal representing the bit value of the addressed memory element.

More particularly the ROM circuit arrangement of the above-mentioned Japanese patent is of the specific kind in which binary bit values are stored by memory elements of a first or second type in accord with the bit value stored thereby, the memory elements being arranged in an addressable matrix, the matrix having columns of serially-connected memory elements, the columns being interconnected to be row-addressable to select a memory element for read-out of its bit value by selection of a row and column, and comprising column selection means connected between said columns and a first circuit node for selecting a column to establish a current path between said first circuit node and a second circuit node, the conduction of which path is dependent on the type of an FET memory element in the selected column selected by row addressing, means for pre-charging one of said circuit nodes to a first potential such that, on row and column selection of a memory element for read-out of its bit value, said one circuit node discharges or not toward a second potential applied to the other circuit node in dependence upon the type of the FET constituting the selected memory element, and read-out means responsive to the resultant potential of said one circuit node to provide a signal representing the bit value of the selected memory element, said read-out means including an isolation transistor having its control electrode connected to said one circuit node and having a load circuit which is isolated from said one circuit node by the isolation transistor and at which said bit value-representing signal is generated.

In the circuits illustrated in the Japanese patent the one circuit node that is pre-charged is taken to positive potential in one embodiment and to ground potential in another. The other circuit node between which and the one, pre-charged, node the selected column of connected to provide a current discharge path, is taken to a different potential whereby the conductivity of the column determined by the addressed circuit element can be tested to provide a signal read-out via the isolation transistor. It will be understood that the discharge of the pre-charged node in this context can mean the flow of current to or from the node dependent on the potentials assumed by the two nodes.

In the two embodiments described in the Japanese patent, the column selection means comprises a respective FET connected between each column and the one, pre-charged node. In the first embodiment each column has an individual other node to which column selection voltages are applied and to which the gate of the respective column selection transistor is connected. Thus the selection or address voltage applied to a given column turns ON the associated selection transistor. This address voltage (+5V) is present while the one node is precharged by a pulse voltage to ground (φ volts). The state of the row-addressed memory element in the selected column is detected by the one node voltage rising or not toward the +5V of the other node after the pulse.

The second embodiment described in the Japanese patent has all the ends of the columns remote from the pre-charged node connected to a common node and the gates of the column selection transistors are separately and individually addressed. In this case the one node is precharged by a pulse to +5V while the common node is held at ground potential and while the selection transistor for the wanted column is turned on.

In each of these embodiments, the pre-charging to a first voltage is done against the application of the second voltage to the column containing the memory element. Particularly if the memory element is conductive the column is likewise conductive to transmit the second voltage. In addition each column selection transistor has its own individual address line, so that an array of $n$ columns requires a 1-out-of-$n$ addressing scheme and $n$ address states.

There will be described, hereinafter, a column selection means which has the advantage of reducing the number of column addressing states as the number of columns increases by use of a tree selection structure. It also enables all columns to be selected in the pre-charging phase whereby each other circuit node or the common other circuit node can be connected in that phase to the same first potential as is used for pre-charging so as to better ensure the one circuit nodes is pre-charged to the first potential.

In accord with the present invention, in a ROM circuit arrangement of the general or specific kind set forth above, the column selection means comprises first and second circuit branches leading from said first circuit node to a respective half of the memory element columns and each comprising a depletion mode and enhancement mode FET connected in series, the gate of the depletion mode FET in each of the first and second branches being connected to the gate of the enhancement mode FET in the second and first branches respectively to provide a first pair of column address lines,

first and second circuit sub-branches leading from said first branch to a respective one fourth of the memory columns, and third and fourth circuit sub-branches leading from said second branch to a respective one fourth of the memory columns, each sub-branch comprising a depletion mode and an enhancement mode FET connected in series, and wherein the gates of the enhancement and depletion mode FETs of the first sub-branch are respectively connected to the gates of the depletion mode and enhancement mode FETs of the second sub-branch to provide a first sub-pair of column address connections, and the gates of enhancement mode and depletion mode FETs of the third sub-branch are respectively connected to the gates of the depletion mode and enhancement mode FETs of the fourth sub-branch to provide a second sub-pair of column address connections, and wherein the column address connections of the first sub-pair are connected to respective column address connections of the second sub-pair to provide a second pair of column address lines.

Where as in the specific kind of ROM outlined above, the circuit arrangement comprises means for pre-charging one of the circuit nodes to a first potential and a second potential is applied to the other circuit node at least during the addressing phase, it is preferred that the second potential be applied by a switchable means which is operable to apply the first potential to the other circuit node simultaneously with the pre-charging of the one circuit node and to apply the second potential to the other circuit node when the selected memory element is addressed for read-out. Thus in the pre-charging phase of operation both ends of the column to be addressed, and of all columns in the preferred embodiment, are at the first potential thereby mitigating the possibility of the one circuit node not being fully charged to the first potential when the address and read-out phase is initiated. This technique is described further below and is referred to as ground switching. In this case the first potential is some volts with respect to ground; the second potential is ground potential.

This ground switching technique may be advantageously applied by having circuit means for switching the other circuit node between the first and second potentials and the pre-charge means for the one circuit node constituted by a circuit element connected between the switchable means and the one circuit node to selectively transmit the first but not the second potential to the one circuit node. The circuit element may be a diode or other device providing unidirectional conduction and leaving the one circuit node isolated from the switching means after the pre-charging phase.

In the preferred ROM circuit arrangement to be described the one circuit node which is pre-charged is the first circuit node from which the branching column selection means leads. The second circuit node is constituted by a circuit node common to all columns. This is a ground switching line in the ground switching technique just described. Thus in the practical implementation each of the first and second nodes is constituted by a respective circuit node common to all columns or stacks.

The ROM circuit arrangement of the invention may further comprise a switching element, e.g., an enhancement mode FET, connected between the first circuit node and the column selection means to act as a page selection means for the matrix of memory elements. The provision of page selection enables two separately paged memory element matrices to share circuitry relating to pre-charging and read-out.

In another aspect the present invention provides a ROM circuit arrangement comprising first and second matrices of FET memory elements each element being of a first or second type in accord with the binary bit value stored thereby, each matrix having columns of serially-connected memory elements, the columns being interconnected to be row-addressable to select a memory element for read-out of its bit value by selection of row and column;

first column selection means connected between the columns of the first matrix and a first circuit node and second column selection means connected between the columns of the second matrix and said first circuit node,

first and second page selection means connected between said first circuit node and respectively said first and second column selection means for selecting said first or second matrix for operative read-out connection with said first circuit node;

means for pre-charging said first circuit node to a first potential:

read-out means responsive to the potential at said first circuit node to provide a signal representing the bit value of an addressed memory element in a selected one of said matrices, said read-out means including an isolation transistor having its control electrode connected to said first circuit node and having a load circuit which is isolated from said first circuit node by the isolation transistor and at which said bit value-representing signal is generated, wherein

said page selection means and column selection means are operable to select a matrix and connect the column thereof containing an addressed memory element between said first circuit node pre-charged to said first potential and a second circuit node connected to a second potential, the column providing a current path between the first and second circuit nodes whose conduction is dependent on the type of the addressed memory element to discharge or not said first circuit node towards said second potential for reading-out the bit value of the addressed circuit element, and characterised in that:

each of said column selection means comprises:

first and second circuit branches leading from the respective page selection means to a respective half of the memory element columns and each comprising a depletion mode and enhancement mode FET connected in series, the gate of the depletion mode FET in each of the first and second branches being connected to the gate of the enhancement mode FET in the second and first branches respectively to provide a first pair of column address lines,

first and second circuit sub-branches leading from said first branch to a respective one fourth of the memory columns, and third and fourth circuit sub-branches leading from said second branch to a respective one fourth of the memory columns, each sub-branch comprising a depletion mode and an enhancement mode FET connected in series, and wherein the gates of the enhancement and depletion mode FETs of the first sub-branch are respectively connected to the gates of the depletion mode and enhancement mode FETs of the second sub-branch to provide a first sub-pair of column address connections, and the gates of enhancement mode and depletion mode FETs of the third sub-branch are respectively connected to the gates of the depletion mode and enhancement mode FETs of the fourth sub-branch to provide a second sub-pair of column address connections, and wherein the column address connections of the first sub-pair are connected to respective column address connections of the second sub-pair to provide a second pair of column address lines.

As will be shown a still larger memory can be provided by interconnecting further such pairs of pages. In an embodiment to be described incorporating these paging features, each page comprises four columns of FET memory elements. The memory elements are referred to in the detailed description as driver transistors. With four columns among which to select, the column selection means comprises four tiers or rows of column select transistors. The first tier has four column select transistors each connected in series with respective one of the four columns. Two of the select transistors are enhancement mode FETs and two are depletion mode FETs. The gates of all four transistors are connected to a single address line. The second tier also comprises four FETs, two of enhancement mode type and two of depletion mode type. Each second tier FET is connected in series with a respective column and FET of the first tier, a depletion mode FET in series with an enhancement mode FET and vice versa. The series connections of complementary type FETs constitute the sub-branches referred to above. The gates of the FETs of the second tier are connected to a single address line.

The third tier of column select FETs comprises two transistors, one an enhancement mode type, the other a depletion mode type. Each is connected in series with a respective pair of transistors in the second tier and thus in series with the pair of complementary transistors in the first tier and a respective two columns. The gates of the two transistors of the third tier are connected to a further address line. Likewise the fourth tier comprises two FETs, one an enhancement mode type, one a depletion mode type. These two transistors are connected in series with the two transistors of the third tier to form complementary pairs which constitute the column selection branches referred to above. The gates of the fourth tier transistors are connected together to a fourth column address line. The fourth tier transistors are both connected to a page select transistor which is an enhancement mode device. The page select transistor leads to the circuit node which receives the precharge for that page and thus is connected in series between the precharged circuit node and the four columns of that page. In the particular embodiment the other ends of the columns are connected to a common switched ground line.

In order that the invention and its practice may be better understood a paged ROM embodying the invention will be described and contrasted with a prior art memory arrangement. The description is taken in conjunction with the accompanying drawings, in which:—

Figure 1 is a schematic diagram of the Kawagoe/Tsuji read only memory circuit described in the article referred to above;

Figure 2 is a diagram showing the basic concept of a read only memory circuit arrangement utilising an isolation transistor to improve the speed of the memory;

Figure 3 is a block diagram of a paged read only memory to which the present invention is applicable;

Figure 4 is a schematic diagram of a portion of one of the memory arrays shown in Figure 3 and embodying the present invention; and,

Figure 5 is a timing diagram for the address and switched ground signals utilized in the memory illustrated in Figures 3 and 4.

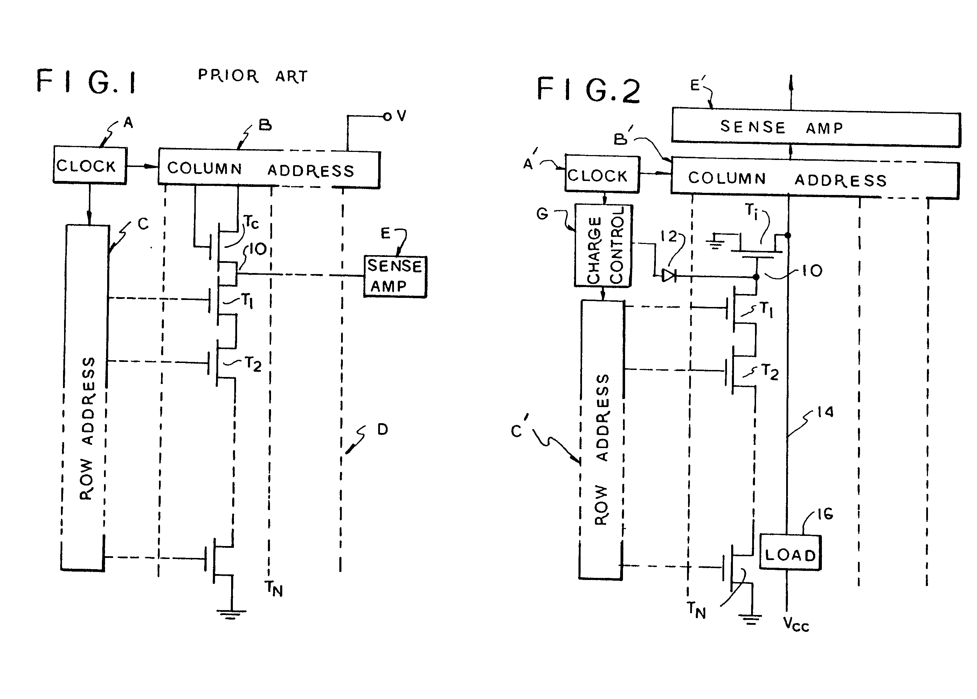

Figure 1 is a schematic representation of the Kawagoe/Tsuji memory disclosed in the above-mentioned article. The memory comprises a timing circuit or clock, generally designated A, which is connected to a column address circuit, generally designated B, and a row address circuit, generally designated C. A matrix array of silicon gate semiconductor transistors, generally designated D, comprises a plurality of columns (only one of which is shown in detail) connected, respectively, to the outputs of column address circuit B. A plurality of row buses are connected to the respective inputs of row address circuit C. A separate sense amplifier, generally designated E, is provided for and connected to each column of the matrix D.

Each column of the matrix D comprises a plurality of P-channel transistors T, each having a control terminal and an output circuit. The output circuits of each of the transistors T are connected in series between ground and an output of column address circuit B. The first or topmost transistor T is designated as $T_C$ because the control terminal thereof is connected to the high level output of clock A, through column address circuit B. The other transistors in the column which act as drivers are designated $T_1, T_2 \ldots T_n$, respectively. Transistor $T_C$ acts as a load for driver transistors $T_1, T_2 \ldots T_n$. The control terminals of each of the driver transistors $T_1, T_2 \ldots T_n$ are, respectively, connected to row address circuit C. In this manner, a cascade ratioless circuit is formed.

Transistor $T_C$ is an enhancement mode transistor. The driver transistors $T_1 \ldots T_n$ provide FET memory elements and consist of either enhancement mode or depletion mode transistors, depending upon the information to be defined thereby. When a particular column is selected by column address circuit B, the output circuit of load transistor $T_C$ is connected to a negative voltage source V and clock A applies a high signal to the control terminal of transistor $T_C$ so as to render same conductive. In this manner, output node 10 is charged to a level close to the level of negative source V. The clock signal is then removed from the control terminal of transistor $T_C$ such that transistor $T_C$ is rendered non-conductive and output node 10 is isolated and, thus, remains charged. Row address circuit C is then actuated to apply a select signal to the control terminal of the selected driver transistor and non-select signals to the control terminals of each of the non-selected transistors, respectively. Preferably, the select signal is a relatively high level (near zero volts), and the non-select signals are of a relatively low level (negative).

For example, assume Transistor $T_2$ is selected and that transistor $T_2$ is a depletion mode transistor. Transistor $T_2$ remains conductive when the high level (zero) select signal is applied thereto. The non-selected enhancement mode transistors, in series with the selected transistor, are turned on by the low (negative) level of the non-select signals applied to their respective control terminals. The non-selected depletion mode transistors remain conductive. Thus, the output level to sense amplifier E is high (near zero volts) because the precharged output node 10 is discharged through the output circuits of transistors $T_1, T_2 \ldots T_n$ to a potential close to ground.

On the other hand, assume transistor $T_3$ is selected and that transistor $T_3$ is an enhancement mode transistor and thus normally non-conductive. The control terminal of transistor $T_3$ receives the select signal, whereas the control terminals of all of the other transistors, respectively, receive the non-select signals. The application of the select signal to the control terminal of transistor $T_3$ retains transistor $T_3$ in the non-conductive state. Thus, the output level applied to the input of sense amplifier E is low (negative) because there is no discharging path for the precharged data node 10.

Thus the signal generated at the sense amplifier E depends on the type of the selected driver transistor and represents the bit value stored thereby.

Figure 2 depicts an improved read only memory circuit. Where appropriate for comparison purposes, the same legend used in Figure 1 is employed with a prime (') to designate a corresponding item in Figure 2. The memory consists of a timing circuit or clock A', a column address circuit B', a row address circuit C', a memory transistor matrix array D', and a sense amplifier E', similar to those described with respect to Figure 1. Again, only a single column is shown for clarity. In this case, a charging control circuit, generally designated G, employs a switch ground technique to generate high and low signals in the proper timed sequence. Circuit G is connected to control node 10' through a diode 12 and, prior to application of the address signals, applies a high signal to node 10' to precharge same. Column selection circuit B' connects the selected output line 14 to the input of sense amplifier E'. Line 14 is connected to a source $V_{cc}$ through load 16 and, thus, will be at a level near $V_{cc}$, unless discharged.

In this case transistor $T_c$, which is the first transistor in each column of matrix D, as shown in Figure 1, has been replaced by an isolation transistor $T_i$ which has a control terminal connected through control node 10' to the series connected output circuits of transistors $T'_1$, $T'_2$ ... $T'_n$ and an output circuit which is connected between ground and column output line 14. Transistor $T_i$ is an enhancement mode transistor and, therefore, is normally non-conductive. However, the application of a high signal on node 10', from charge control circuit G, renders transistor $T_i$ conductive so as to connect line 14 to ground. Transistors $T_1$, $T_2$ ... $T_n$ are either depletion mode or enhancement mode, N-channel transistors, depending upon the information defined thereby.

When the row and column select signals are applied, the output of charging control circuit G changes from high to low. However, control node 10' remains charged because diode 12 prevents the charge thereon from dissipating through control circuit G.

The row select signals include select signals which are low level (in this case, near zero volts) and non-select signals which are high level (in this case, positive). A select signal is applied to the control terminal of the driver transistor in the selected row while the control terminals of all of the other transistors receive the non-select signals.

If the select signal is applied to a depletion mode transistor, it remains conductive, the non-selected enhancement mode driver transistors are rendered conductive, and the non-selected depletion mode driver transistors remain conductive. Hence, control node 10', and thus the control terminal of transistor $T_i$, are connected to ground, turning transistor $T_i$ off so as to prevent the discharging of the output line 14 to ground through the output circuit of transistor $T_i$. Thus, sense amplifier E detects a high level output.

On the other hand, if an enhancement mode transistor is selected, this transistor will remain non-conductive, thus preventing control node 10' from discharging, and thus the control terminal of transistor $T_i$ from being connected to ground through the series connected output circuits of the driver transistors. In this case, transistor $T_i$ remains conductive and output line 14 is discharged to ground. Thus, sense amplifier E detects a low level input.

As illustrated in Figure 2, each column or stack of the memory circuit is provided with a single isolation transistor $T_i$. However, the isolation transistor $T_i$ must be larger than the driver transistors in order to achieve the desired speed. It is therefore possible to significantly enhance the density of the memory circuit by using a single isolation transistor for multiple stacks or columns. The manner in which this is accomplished is described below and is the preferred form of the present invention.

It will be appreciated that transistor $T_i$ functions to isolate the series connected driver transistors $T'_1$ ... $T'_n$ from the load circuit 14, 16. This is important because the series connected driver transistors form a circuit with a relatively high impedance, because of the large number thereof. Since the output line 14 is connected to a relatively high capacitive load, connecting the output circuit directly to the series connected driver transistors would result in a relatively long discharge time for line 14. This problem is eliminated in the present invention, in order to significantly reduce the delay time, by isolating or buffering the output line 14 from the series connected driver transistors by means of transistor $T_i$. In addition, it will be appreciated that transistor $T_i$ is connected so that it also serves to provide a second function, that is, output line 14 is discharged through its output circuit if the selected driver transistor is rendered conductive.

Further, by isolating the driver transistor circuit from the output load, the number of transistors in the driver transistor circuit may be increased without significantly increasing the delay time. Thus, the size of the memory is no longer restricted as it is in the Kawagoe/Tsuji circuit.

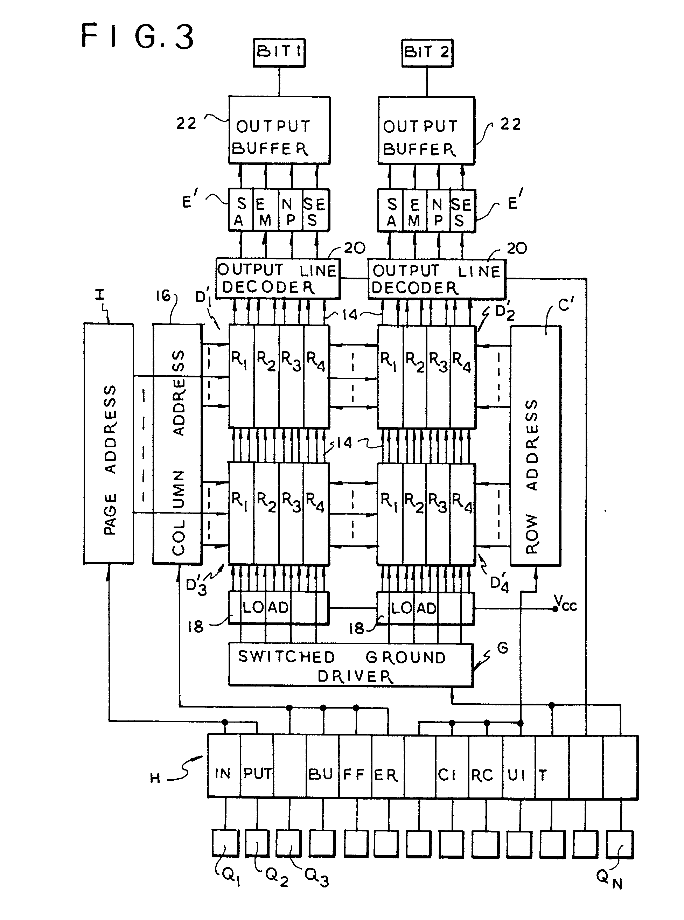

Figure 3 is a block diagram of a simplified read only memory employing the present invention. The read only memory depicted in Figure 3 shows only a two bit memory. However, it should be understood that the memory can be expanded to include larger numbers of bits by simple duplication of parts, same being well within the ordinary skill in the art.

The matrix D' of memory cells is shown as comprising four separate sub-matrices, $D'_1$ ... $D'_4$, each represented by a rectangular box. Each pair of vertically aligned sub-matrices D contains the information for one memory bit. Each of the boxes D' contains four sub-divisions $R_1$ ... $R_4$. Each sub-division $R_1$ ... $R_4$, in turn, contains four pages, $P_1$ ... $P_4$, as described in detail below.

Each page P includes four parallelly situated columns or stacks, each of the columns or stacks comprising a plurality of series connected driver transistors $T'_1$ ... $T'_n$, which may either be enhancement mode or depletion mode transistors, depending upon the information contained therein. Each page P also contains column selection means and page select means. The column select means is designed to select a single column or stack and to connect same, through a page select means, to the control node, when the page select means is actuated.

Within each sub-division R of each sub-matrix $D'_1$ ... $D'_4$, there are two side-by-side pairs of vertically aligned pages P. The stacks in each vertically aligned page pair are operably connected, through their respective page select means and column select means, to a single control node 10'. The control node 10' is, in turn, connected to the control terminal of a single isolation transistor $T_i$. The output circuit of the

isolation transistor $T_i$ is connected between ground and the column output line 14 provided for the vertically aligned page pair.

The peripheral circuitry includes a plurality of chip inputs $Q_1 \ldots Q_n$, each of which is connected to a different one of a plurality of input buffer circuits, respectively, which, in aggregate, are generally designated H. Each one of the input buffer circuits H has two outputs (only one of which is shown), generating separate but complementary signals, based on its input.

The outputs of one of the input buffer circuits H are applied to the input of a page address circuit, generally designated I. The page address circuit I receives complementary input signals and generates a pair of page select signals to each sub-division R in each set of horizontally aligned sub-matrices D'. Similarly, two of the input buffer circuits H are connected to the input of column address circuit 16. The two pairs of complementary outputs from column address circuit 16 are connected to each page P of each sub-division R in each set of horizontally aligned sub-matrices D' and serve to select one of four columns or stacks in the page. Row address circuit C' is also connected to the outputs of seven of the input buffer circuits H. In accordance with the complementary output signals from these input buffer circuits H, row address circuit C, which has a plurality of output lines, one for each driver transistor in each vertically aligned page P of each sub-division R of each set of horizontally aligned sub-matrices D', generates the select signal to the selected row and non-select signals to all other rows.

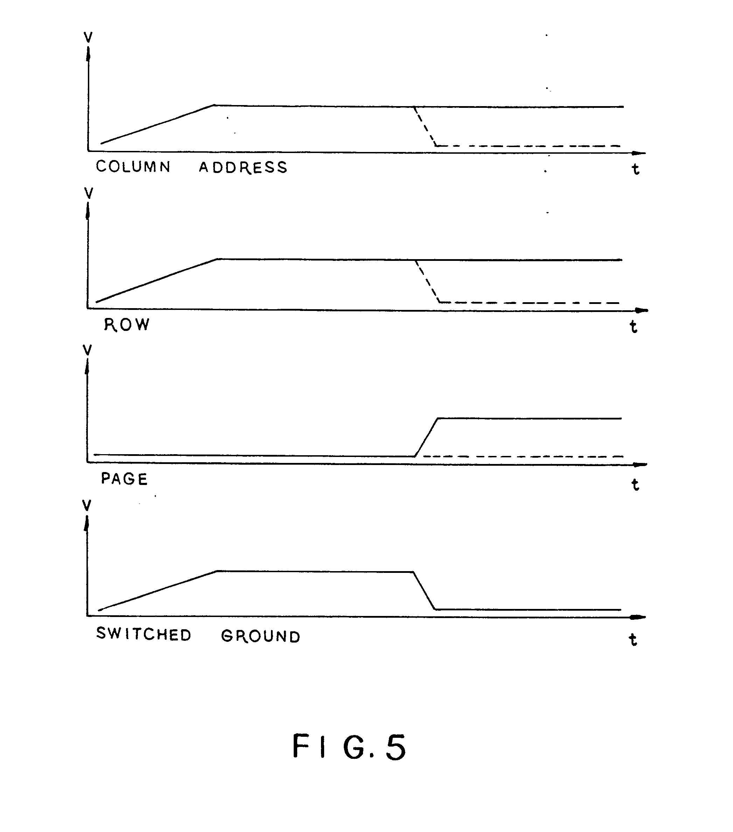

A switched ground driver circuit G is connected to the output of two of the input buffer circuits H to receive two pairs of complementary inputs, and generates a switched ground output to all vertically aligned sub-divisions R in each set of vertically aligned sub-matrices D'. The switched ground output and all column and row address output signals will be high prior to addressing, whereas the page address output signals will all be low prior to addressing, as illustrated in Figure 5.

Each pair of vertically aligned pages in each sub-division R is provided with a column output line 14 which is connected between a load circuit 18 and an output line decoder circuit 20. Vertically aligned sub-divisions R share the same output lines 14. Each column output line 14 is connected through load 18 to a source of positive potential $V_{cc}$. Thus, all output lines 14 are normally at a positive potential.

An output line decoder circuit 20 is provided for each bit. Output line decoder circuits 20 are connected to one of the input buffer circuits H and function to connect a selected column output line 14 to one of four sense amplifiers in each sense amplifier circuit E', one of which is provided for each bit.

Each sense amplifier in each circuit E' is thus associated with one set of vertically aligned sub-divisions R in each of the vertically aligned sub-matrices D'. All of the four sense amplifiers in each of the circuits E' are connected to a single output buffer 22 for that bit.

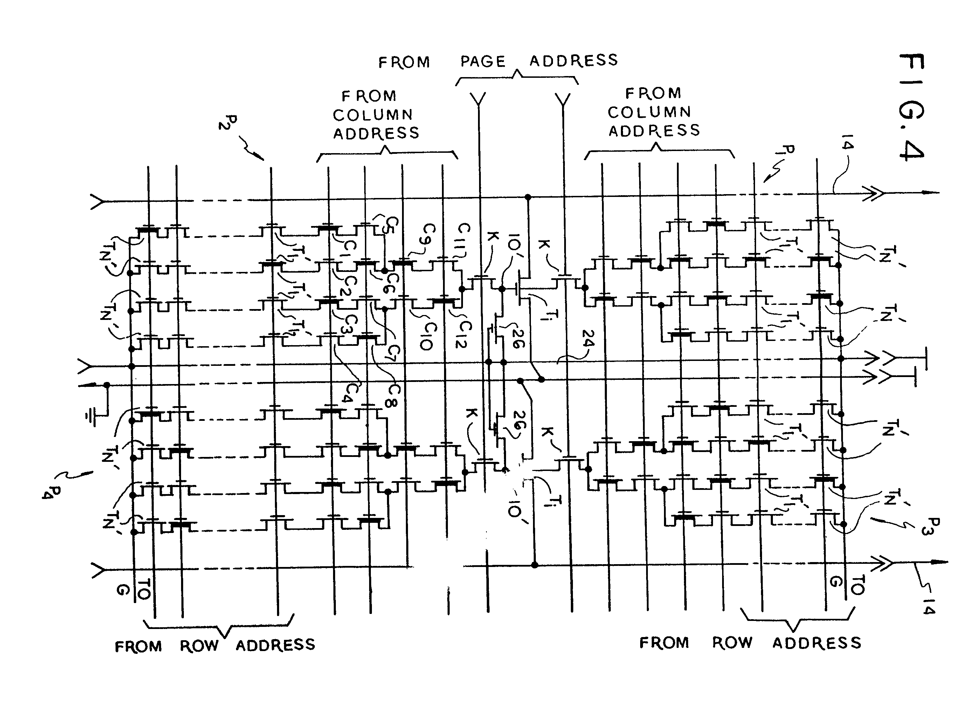

The specific structure of each of the sub-divisions R can best be appreciated by referring to Figure 4, which illustrates a typical sub-division R. Figure 4 shows two pairs of vertically aligned pages $P_1 \ldots P_4$. Each page P comprises four parallel columns or stacks of series connected driver transistors $T'_1 \ldots T'_n$. Driver transistors $T'_1 \ldots T'_n$ are either enhancement mode or depletion mode transistors in accordance with the bit value information to be contained in the memory. Throughout the figure, enhancement mode transistors are depicted as comprising a thin body portion and depletion mode transistors are depicted as comprising a thick body on the diagram. The driver transistors provide a basic matrix unit of memory elements in which any one is addressable by row and column. Corresponding transistors in the four columns are connected as shown for row addressing. The column selection or addressing is done by means to be described.

Each of the four columns or stacks of driver transistors in each page P are connected between the output of switched ground driver circuit G and a column select means. Each of the column select means comprises four horizontal rows of transistors, each row receiving a different output from column address circuit 16. The horizontal row of column select transistors nearest the columns or stacks each consist of a depletion mode transistor $C_1$, an enhancement mode transistor $C_2$, a depletion mode transistor $C_3$, and an enhancement mode transistor $C_4$. The respective output circuits of transistors $C_1 \ldots C_4$ are connected between one of the columns or stacks on the one hand, and the transistors $C_5$ through $C_8$ on the other hand, which form the next row of the column select circuit. Transistor $C_5$ is an enhancement mode transistor, transistor $C_6$ is a depletion mode transistor, transistor $C_7$ is an enhancement mode transistor, and transistor $C_8$ is a depletion mode transistor.

The next horizontal row of transistors in the column select circuit consists of only two transistors $C_9$ and $C_{10}$. Transistor $C_9$ is a depletion mode transistor and $C_{10}$ is an enhancement mode transistor. The output circuit of transistor $C_9$ is connected to the output circuits of both transistors $C_5$ and $C_6$. Similarly, the output circuit of transistor $C_{10}$ is connected to the output circuits of transistors $C_7$ and $C_8$.

The fourth and last horizontal row of column select transistors comprises two transistors $C_{11}$ and $C_{12}$. The output circuit of transistor $C_{11}$ is connected between the output circuit of transistor $C_9$ and the output circuit of an enhancement mode page select transistor K. The output circuit of transistor $C_{12}$ is connected between the output circuit of transistor $C_{10}$ and the output circuit of page select transistor K.

The output circuit of page select transistor K is connected between the column select means and control node 10' which, in turn, is connected to the control terminal of the isolation transistor $T_I$, one of which is provided for each pair of vertically aligned pages P. Control node 10' is operably connected to the output of the switched ground driver circuit G through line 24 and a transistor 26. Transistor 26 has its control terminal also tied to the output of switched ground driver circuit G, via line 24, and thus functions as a diode similar to diode 12 shown in Figure 2.

Prior to addressing, the output of switched ground driver circuit G is a high such that control node 10' is charged to a high level through transistor 26. All page address signals are low. All column and row address signals are high. When all of the row address signals are high, all driver transistors are conductive, thereby connecting the output circuits of column select transistors $C_1$ through $C_4$ to the output of switched ground driver G through the respective stacks. When all of the column address signals are high, all of the stacks are connected to page select transistor K. At this point, any feed through page select transistor K would tend to dissipate the charge on control node 10' if transistor $T'_n$ of each stack were not connected to a source of high potential. It is for this reason that transistor $T'_n$ in each stack is connected to the output of switched ground driver G which is, during this period, at a high potential.

The output of switched ground driver circuit G now changes to a low level (ground) such that the end of each stack is connected to ground. However, the charge on control node 10' cannot dissipate through the switched ground driver circuit G because of transistor 26 which acts as a diode to prevent same. As the output of circuit G switches, the page, column and row select signals, and the output line decoder signals are generated and applied.

The selection process serves to select a row, a page, and to operably connect a selected stack or column in the selected page with the control node 10' associated with the selected page. For example, suppose the third driver transistor $T_3$ in the third column of page $P_2$, which appears on the lower left-hand corner of Figure 4, is to be selected. A row select signal is applied to the third output line from row address circuit C'. All other row address output lines receive non-select signals. The page select signal applied to the page select transistors K for all pages in the lower half of all of the horizontally aligned sub-matrices D' will be high so as to render the corresponding page select transistors K conductive. The outputs on all other page select inputs will be low, keeping all other page select transistors K non-conductive, thereby disconnecting those pages from the corresponding control nodes 10'.

Four separate column select signals are applied to the four separate column select lines associated with the selected pages. In order to select the third column or stack of the page, the column select signal applied to column select transistors $C_1 \ldots C_4$ will be low, causing transistors $C_1$ and $C_3$

to remain conductive and transistors $C_2$ and $C_4$ to be non-conductive. The column select signal applied to the control terminals of column select transistors $C_5 \ldots C_8$ will be high such that transistors $C_5$ and $C_7$ will be rendered conductive and transistors $C_6$ and $C_8$ rendered non-conductive. The column select signal applied to the control terminals of transistors $C_9$ and $C_{10}$ will be high, thereby rendering transistor $C_9$ non-conductive and transistor $C_{10}$ conductive. The column select signal applied to the control terminals of transistors $C_{11}$ and $C_{12}$ will be low, such that transistor $C_{11}$ is turned off and transistor $C_{12}$ is turned on. Thus, column select transistors $C_3$, $C_7$, $C_{10}$ and $C_{12}$ will all be rendered conductive by the column select signals, thereby connecting the third column or stack, through conductive page select transistor K, with control node 10'.

The select row address signal applied to the control terminal of driver transistor $T_3$ is a low level signal and the non-select signals are high level signals. Thus, if the select signal is applied to a depletion mode transistor, the non-selected enhancement mode transistors are rendered conductive (non-selected depletion mode transistors remain conductive), and control node 10' is operably connected to the output of switched ground driver circuit G, which is ground, through the selected page select transistor K, the selected column select transistors $C_3$, $C_7$, $C_{10}$ and $C_{12}$, and the series connected driver transistors in the selected column or stack. In this way, the charge on control node 10' will dissipate through the switched ground driver circuit G, causing isolation transistor $T_I$ to become non-conductive. When isolation transistor $T_I$ becomes non-conductive, the column output line 14 associated with that isolation transistor becomes isolated from line 24 and, thus, from ground and thereafter rapidly charges to a positive potential, near $V_{CC}$, through load 18.

If, on the other hand, the selected driver transistor $T_3$ were an enhancement mode transistor, the application of the low level select signal thereto would not render same conductive. Therefore, the control node 10' would continue to be isolated from the grounded output of switched ground driver circuit G, control node 10' would maintain its charge, isolation transistor $T_I$ would continue to be conductive and function to connect the column output line 14 to ground, via line 24, preventing line 14 from charging to near the positive $V_{CC}$ level, through load 18.

Each of the column output lines 14 is connected through output line decoder circuit 20 to one of the sense amplifiers in sense amplifier circuit E'. Output line decoder circuit 20 is operably connected to the output of one of the input buffer circuits H, which causes the output line decoder circuit 20 to select only the column output line 14 of interest for connection to the corresponding sense amplifier in sense amplifier circuit E'. In this case, the column output line 14 of interest is the line shown on the lefthand side of Figure 4. Thus, column output line 14 is connected through column decoder circuit 20 to the sense amplifier shown at the left of sense amplifier circuit E'. The sense amplifier senses whether the column output line 14 of interest is at a high level signal or a low level signal, after page, column and row selections have taken place. The sense amplifier generates a signal which is a function of the state of the sensed level on output line 14 and applies same to an output buffer circuit 22. Circuit 22 latches the output, by means of a bistable circuit and generates either a high or low level signal to represent the output of the addressed bit. Since the output buffer serves to latch the output signal corresponding to each bit, each bit in the memory can be addressed in sequence in order to read out a data word having a plurality of bits therein.

Figure 5 graphically illustrates the time relationship between the column address, row address, page address and switched ground signals. Each graph shows magnitude plotted against time.

Prior to addressing, the column address and row address signals are all positive. Thus, all driver transistors and column select transistors are conductive. The switched ground signal is also positive prior to addressing, during the period when the control node is charged. The page address signals are, however, low during this period.

The page address signals are kept low during precharge to prevent any dissipation of charge from the control node through the stacks, which are conductive. However, even if some feed through the page select transistors should occur prior to addressing, dissipation of charge through the stack is prevented because the switched ground signal, also high during precharge, is connected to the far end of each stack.

When address occurs, the column address signals will remain high or become low, depending upon the column selected. The row address signals become low (select), or remain high (non-select). Page address signals either remain low or change to high.

The switched ground signals alternate between high, for control node precharge, and low, during addressing and information read-out. During the low period, control node charging ceases (but discharge through the switched ground driver is prevented) and discharge through the far end of each stack is possible.

## Claims

1. A ROM circuit arrangement in which binary bit values are stored by FET memory elements $(T_1'—T_N')$ of a first or second type in accord with the bit value stored thereby, the memory elements being arranged in an addressable matrix of rows and columns, the memory elements of each column being serially-connected to provide a selectable current path between first (10') and second circuit nodes, and comprising column selection means connected between said columns and said first circuit node (10') to perform the column addressing of an addressed memory element, the conductivity of the current path through the selected column being determined by which type the addressed memory element is, and read-out means $(T_l)$ responsive to the conductivity of the current path through the selected column to provide a signal representing the bit value of the addressed memory element, characterised in that the column selection means comprises:

first $(C_9, C_{11})$ and second $(C_{10}, C_{12})$ circuit branches leading from said first circuit node (10') to a respective half of the memory element columns and each comprising a depletion mode and enhancement mode FET connected in series, the gate of the depletion mode FET in each of the first $(C_9, C_{11})$ and second $(C_{10}, C_{12})$ branches being connected to the gate of the enhancement mode FET in the second $(C_{10}, C_{12})$ and first $(C_9, C_{11})$ branches respectively to provide a first pair of column address lines,

first $(C_1, C_5)$ and second $(C_2, C_6)$ circuit sub-branches leading from said first branch $(C_9, C_{11})$ to a respective one fourth of the memory columns and third $(C_3, C_7)$ and fourth $(C_4, C_8)$ circuit sub-branches leading from said second branch $(C_{10}—C_{12})$ to a respective one fourth of the memory columns, each sub-branch comprising a depletion mode and an enhancement mode FET connected in series, and wherein the gates of the enhancement and depletion mode FETs of the first sub-branch $(C_1, C_5)$ are respectively connected to the gates of the depletion mode and enhancement mode FETs of the second sub-branch $(C_2, C_6)$ to provide a first sub-pair of column address connections, and the gates of enhancement mode and depletion mode FETs of the third sub-branch $(C_3, C_7)$ are respectively connected to the gates of the depletion mode and enhancement mode FETs of the fourth sub-branch $(C_4, C_8)$ to provide a second sub-pair of column address connections, and wherein the column address connections of the first sub-pair are connected to respective column address connections of the second sub-pair to provide a second pair of column address lines.

2. A ROM circuit arrangement in which binary bit values are stored by memory elements $(T_1'—T_N')$ of a first or second type in accord with the bit value stored thereby, the memory elements being arranged in an addressable matrix, the matrix having columns of serially-connected memory elements, the columns being interconnected to be row-addressable to select a memory element for read-out of its bit value by selection of a row and column, and comprising column selection means connected between said columns and a first circuit node (10') for selecting a column to establish a current path between said first circuit node and a second circuit node, the conductivity of which path is dependent on the type of an FET memory element in the selected column selected by row addressing, means (12) for pre-charging one (10') of said circuit nodes to a first potential such that, on row and column selection of a memory element for read-out of its bit value, said one circuit node (10') discharges or not toward a second potential applied to the other circuit node in dependence upon the type of the FET constituting the selected memory element, and read-out means (T$_i$, 14, 16) responsive to the resultant potential of said one circuit node to provide a signal representing the bit value of the selected memory element, said read-out means including an isolation transistor (T$_i$) having its control electrode connected to said one circuit node (10') and having a load circuit (16) which is isolated from said one circuit node (10') by the isolation transistor (T$_i$) and at which said bit value-representing signal is generated, characterised in that the column selection means comprises:

first (C$_9$, C$_{11}$) and second (C$_{10}$, C$_{12}$) circuit branches leading from said first circuit node (10') to a respective half of the memory element columns and each comprising a depletion mode and enhancement mode FET connected in series, the gate of the depletion mode FET in each of the first (C$_9$, C$_{11}$) and second (C$_{10}$, C$_{12}$) branches being connected to the gate of the enhancement mode FET in the second (C$_{10}$, C$_{12}$) and first (C$_9$, C$_{11}$) branches respectively to provide a first pair of column address lines,

first (C$_1$, C$_5$) and second (C$_2$, C$_6$) circuit sub-branches leading from said first branch (C$_9$, C$_{11}$) to a respective one fourth of the memory columns and third (C$_3$, C$_7$) and fourth (C$_4$, C$_8$) circuit sub-branches leading from said second branch (C$_{10}$—C$_{12}$) to a respective one fourth of the memory columns, each sub-branch comprising a depletion mode and an enhancement mode FET connected in series, and wherein the gates of the enhancement and depletion mode FETs of the first sub-branch (C$_1$, C$_5$) are respectively connected to the gates of the depletion mode and enhancement mode FETs of the second (C$_2$, C$_6$) to provide a first sub-pair of column address connections, and the gates of enhancement mode and depletion mode FETs of the third sub-branch (C$_3$, C$_7$) are respectively connected to the gates of the depletion mode and enhancement mode FETs of the fourth sub-branch (C$_4$, C$_8$) to provide a second sub-pair of column address connections, and wherein the column address connections of the first sub-pair are connected to respective column address connections of the second sub-pair to provide a second pair of column address lines.

3. A ROM circuit arrangement as claimed in Claim 1 comprising means (12) for charging one of said circuit nodes to a first potential, means (G) to apply a second potential to the other circuit node upon addressing of the selected memory element whereby said one circuit node (10') discharges or not toward said second potential in dependence upon the conductivity of the current path provided by the selected column, said read-out means (T$_i$, 14, 16) being responsive to the potential at said one circuit node (10') and wherein said means (G) to apply said second potential is switchable to apply said first potential to said other circuit node simultaneously with the pre-charging of said one circuit node (10') and to apply said second potential to said other circuit node when the selected memory element is addressed for read-out.

4. A ROM circuit arrangement as claimed in Claim 1 or 3 in which said read-out means (T$_i$, 14, 16) includes an isolation transistor (T$_i$) having its control electrode connected to said one circuit node (10') and having a load circuit (16) which is isolated from said one circuit node (10') by said isolation transistor (T$_i$) and at which said bit value-representing signal is generated.

5. A ROM circuit arrangement as claimed in Claim 2 comprising means (G) switchable to apply said first potential to the other of said circuit nodes simultaneously with the application of said first potential to said first circuit node (10') and to apply said second potential to said other circuit node upon addressing of the selected memory element.

6. A ROM circuit arrangement as claimed in Claim 3, 4 or 5 in which said means (12) for pre-charging said one circuit node (10') comprises a circuit element (12) connected between said one circuit node (10') and said switchable means (G) to selectively transmit said first potential but not said second potential to said one circuit node (10').

7. A ROM circuit arrangement as claimed in any one of Claims 2 to 6 in which said one circuit node (10') is said first circuit node (10').

8. A ROM circuit arrangement as claimed in Claim 7 in which said second circuit node is constituted by a circuit node common to all columns.

9. A ROM circuit arrangement as claimed in any one of Claims 1 to 6 in which each of said first (10') and second circuit nodes is constituted by a respective circuit node common to all columns.

10. A ROM circuit arrangement as claimed in any preceding claim comprising a switching element (K) connectable in circuit between said column selection means (C$_1$—C$_{12}$) and said first circuit node (10') to act as a page selection means for said matrix of memory elements.

11. A ROM circuit arrangement as claimed in Claim 10 in which said switching element (K) comprises an enhancement mode FET.

12. A ROM circuit arrangement comprising:

first (P$_1$) and second (P$_2$) matrices of FET memory elements (T$_1$'—T$_N$') each element being of a first or second type in accord with the binary bit value stored thereby, each matrix (P$_1$, P$_2$) having columns of serially-connected memory elements, the columns being interconnected to be row-addressable to select a memory element for read-out of its bit value by selection of row and column;

first column selection means connected between the columns of the first matrix (P$_1$) and a first circuit node (10') and second column selection means connected between the columns of the second matrix (P$_2$) and said first circuit node (10'),

first and second page selection means (K) connected between said first circuit node (10') and respectively said first and second column selection means for selecting said first (P₁) or second (P₂) matrix for operative readout connection with said first circuit node (10');

means (12) for pre-charging said first circuit node (10') to a first potential:

read-out means (T₁, 14, 16) responsive to the potential at said first circuit node (10') to provide a signal representing the bit value of an addressed memory element in a selected one of said matrices (P₁, P₂), said read-out means including an isolation transistor (Tᵢ) having its control electrode connected to said first circuit node (10') and having a load circuit (16) which is isolated from said first circuit node (10') by the isolation transistor (Tᵢ) and at which said bit value-representing signal is generated, wherein

said page selection means (K) and column selection means are operable to select a matrix and connect the column thereof containing an addressed memory element between said first circuit node (10') pre-charged to said first potential and a second circuit node connected to a second potential, the column providing a current path between the first and second circuit nodes whose conduction is dependent on the type of the addressed memory element to discharge or not said first circuit node (10') towards said second potential for reading-out the bit value of the addressed circuit element, and characterised in that:

each of said column selection means comprises:

first (C₉, C₁₁) and second (C₁₀, C₁₂) circuit branches leading from the respective page selection means (K) to a respective half of the memory element columns and each comprising a depletion mode and enhancement mode FET connected in series, the gate of the depletion mode FET in each of the first (C₉, C₁₁) and second (C₁₀, C₁₂) branches being connected to the gate of the enhancement mode FET in the second (C₁₀, C₁₂) and first (C₉, C₁₁) branches respectively to provide a first pair of column address lines,

first (C₁, C₅) and second (C₂, C₆) circuit sub-branches leading from said first branch (C₉, C₁₁) to a respective one fourth of the memory columns and third (C₃, C₇) and fourth (C₄, C₈) circuit sub-branches leading from said second branch (C₁₀, C₁₂) to a respective one fourth of the memory columns, each sub-branch comprising a depletion mode and an enhancement mode FET connected in series, and wherein the gates of the enhancement and depletion mode FETs of the first sub-branch (C₁, C₅) are respectively connected to the gates of the depletion mode and enhancement mode FETs of the second (C₂, C₆) to provide a first sub-pair of column address connections, and the gates of enhancement mode and depletion mode FETs of the third sub-branch (C₃, C₇) are respectively connected to the gates of the depletion mode and enhancement mode FETs of the fourth sub-branch (C₄, C₈) to provide a second sub-pair of column address connections, and wherein the column address connections of the first sub-pair are connected to respective column address connections of the second sub-pair to provide a second pair of column address lines.

13. A ROM circuit arrangement as claimed in Claim 12, in which each of said first and second page selection means (K) comprises an enhancement mode FET.

14. A ROM circuit arrangement as claimed in Claim 12 or 13 in which the ends of the columns of the first matrix are connected to a common first further circuit node and the ends of the columns of the second matrix are connected to a common second further circuit node, and further comprising means (G) switchable to apply said first potential to said first and second further circuit nodes simultaneously with the pre-charging of the first circuit node to said first potential and to apply said second potential to said first and second further circuit nodes when the selected memory element in the selected matrix is addressed for read-out.

15. A ROM circuit arrangement as claimed in Claim 14 in which said means (12) for pre-charging said first circuit node comprises a circuit element (12) connected between said first circuit node (10') and said switchable means (G) to transmit said first but not said second potential to said first circuit node (10').

**Patentansprüche**

1. ROM-Schaltungsanordnung, in der binäre Bitwerte durch FET-Speicherelemente (T₁'—T_N') eines ersten oder zweiten Typs gemäß dem damit gespeicherten Bitwert gespeichert werden, wobei die Speicherelemente in einer adressierbaren Matrix aus Reihen und Spalten angeordnet und die Speicherelemente einer jeden Spalte in Reihe verbunden sind, um zwischen ersten (10') und zweiten Schaltungsknoten einen auswählbaren Strompfad zu bilden, und die eine Spaltenauswahleinrichtung aufweist, die zwischen die Spalten und den ersten Schaltungsknoten (10') geschaltet ist, um die Spaltenadressierung eines adressierten Speicherelements auszuführen, wobei die Leitfähigkeit des Strompfads durch die ausgewählte Spalte durch den Typ des adressierten Speicherelements bestimmt wird, und eine Ausleseeinrichtung (Tᵢ), die auf die Leitfähigkeit des Strompfads durch die ausgewählte Spalte reagiert, um ein Signal zu erzeugen, das den Bitwert des adressierten Speicherelements repräsentiert, dadurch gekennzeichnet, daß die Spaltenauswahleinrichtung aufweist:

einen ersten (C₉, C₁₁) und einen zweiten (C₁₀, C₁₂) Schaltungszweig, die vom ersten Schaltungsknoten (10') zu einer zugehörigen Hälfte der Speicherelementespalten führen und je einen Verarmungsbetrieb-FET und einen Anreicherungsbetrieb-FET aufweisen, die in Reihe geschaltet sind, wobei das Gate des Verarmungsbetrieb-FET in jedem von dem ersten (C₉, C₁₁) und dem zweiten (C₁₀, C₁₂) Zweig mit dem Gate des Anreicherungsbetrieb-FET in dem zweiten ($C_{10}$, $C_{12}$) bzw. dem ersten ($C_9$, $C_{11}$) Zweig verbunden ist, um ein erstes Paar von Spaltenadressenleitungen zu bilden,

einen ersten ($C_1$, $C_5$) und einen zweiten ($C_2$, $C_6$) Schaltungsunterzweig, die vom ersten Zweig ($C_9$, $C_{11}$) zu je einem Viertel der Speicherspalten führen, und einen dritten ($C_3$, $C_7$) und einen vierten ($C_4$, $C_8$) Schaltungsunterzweig, die vom zweiten Zweig ($C_{10}$, $C_{12}$) zu je einem zugehörigen Viertel der Speicherspalten führen, wobei jeder Unterzweig einen Verarmungsbetrieb-FET und einen Anreicherungsbetrieb-FET aufweist, die in Reihe geschaltet sind, und wobei das Gate des Anreicherungsbetrieb-FET und das Gate des Verarmungsbetrieb-FET des ersten Unterzweiges ($C_1$, $C_5$) mit dem Gate des Verarmungsbetrieb-FET bzw. mit dem Gate des Anreicherungsbetrieb-FET des zweiten Unterzweiges ($C_2$, $C_6$) verbunden ist, um ein erstes Unterpaar von Spaltenadressenverbindungen zu bilden, und wobei das Gate des Anreicherungsbetrieb-FET und das Gate des Verarmungsbetrieb-FET des dritten Unterzweiges ($C_3$, $C_7$) mit dem Gate des Verarmungsbetrieb-FET bzw. dem Gate des Anreicherungsbetrieb-FET des vierten Unterzweigs ($C_4$, $C_8$) verbunden ist, um ein zweites Unterpaar von Spaltenadressenverbindungen zu bilden, und wobei die Spaltenadressenverbindungen des ersten Unterpaares je mit den Spaltenadressenverbindungen des zweiten Unterpaares verbunden sind, um ein zweites Paar von Speicheradressenleitungen zu bilden.

2. ROM-Schaltungsanordnung, in der Binärbitwerte durch Speicherelemente ($T_1'$—$T_N'$) eines ersten oder eines zweiten Typs gemäß dem damit gespeicherten Bitwert gespeichert werden, wobei die Speicherelemente in einer adressierbaren Matrix angeordnet sind, die Matrixspalten aus in Reihe geschalteten Speicherelementen aufweist, und die Spalten so miteinander verbunden sind, daß sie reihenadressierbar sind, um durch Auswahl einer Reihe und einer Spalte ein Speicherelement zum Auslesen seines Bitwerts auszuwählen, und die eine zwischen die Spalten und einen ersten Schaltungsknoten (10') geschaltete Spaltenauswahleinrichtung zum Auswählen einer Spalte aufweist, um einen Strompfad zwischen dem ersten Schaltungsknoten und einem zweiten Schaltungsknoten zu bilden, wobei die Leitfähigkeit dieses Pfads abhängt vom Typ eines FET-Speicherelements in der ausgewählten Spalte, das durch Zeilenadressierung ausgewählt worden ist, eine Einrichtung (12) zum Vorladen eines (10') der Schaltungsknoten auf ein erstes Potential derart, daß sich dieser eine Schaltungsknoten (10') bei Reihen- und Spalten-Auswahl eines Speicherelements zum Auslesen von dessen Bitwert zu einem an den anderen Schaltungsknoten angelegten zweiten Potential hin entlädt oder nicht, und zwar in Abhängigkeit von dem Typ des das ausgewählte Speicherelement bildenden FET, und eine Ausleseeinrichtung ($T_i$, 14, 16), die auf das resultierende Potential des einen Schaltungsknotens mit der Erzeugen eines den Bitwert des ausgewählten Speicherelements repräsentierenden Signals reagiert, wobei die Ausleseeinrichtung einen Isoliertransistor ($T_i$) aufweist, dessen Steuerelektrode mit diesem einen Schaltungsknoten (10') verbunden ist und der eine Lastschaltung (16) aufweist, die von diesem einen Schaltungsknoten (10') durch den Isoliertransistor ($T_i$) isoliert ist und in welcher das den Bitwert repräsentierende Signal erzeugt wird,

dadurch gekennzeichnet, daß die Spaltenauswahleinrichtung aufweist:

einen ersten ($C_9$, $C_{11}$) und einen zweiten ($C_{10}$, $C_{12}$) Schaltungszweig, die vom ersten Schaltungsknoten (10') zu einer zugehörigen Hälte der Speicherelementespalten führen und je einen Verarmungsbetrieb-FET und einen Anreicherungsbetrieb-FET aufweisen, die in Reihe geschaltet sind, wobei das Gate des Verarmungsbetrieb-FET in jedem von dem ersten ($C_9$, $C_{11}$) und dem zweiten ($C_{10}$, $C_{12}$) Zweig mit dem Gate des Anreicherungsbetrieb-FET in dem zweiten ($C_{10}$, $C_{12}$) bzw. dem ersten ($C_9$, $C_{11}$) Zweig verbunden ist, um ein erstes Paar von Spaltenadressenleitungen zu bilden,

einen ersten ($C_1$, $C_5$) und einen zweiten ($C_2$, $C_6$) Schaltungsunterzweig, die vom ersten Zweig ($C_9$, $C_{11}$) zu je einem Viertel der Speicherspalten führen, und einem dritten ($C_3$, $C_7$) und einem vierten ($C_4$, $C_8$) Schaltungsunterzweig, die vom zweiten Zweig ($C_{10}$, $C_{12}$) zu je einem Viertel der Speicherspalten führen, wobei jeder Unterzweig einen Verarmungsbetrieb-FET und einen Anreicherungsbetrieb-FET aufweist, die in Reihe geschaltet sind, und wobei das Gate des Anreicherungsbetrieb-FET und das Gate des Verarmungsbetrieb-FET des ersten Unterzweiges ($C_1$, $C_5$) mit dem Gate des Verarmungsbetrieb-FET bzw. mit dem Gate des Anreicherungsbetrieb-FET des zweiten Unterzweiges ($C_2$, $C_6$) verbunden ist, um ein erstes Unterpaar von Spaltenadressenverbindungen zu bilden, und wobei das Gate des Anreicherungsbetrieb-FET und das Gate des Verarmungsbetrieb-FET des dritten Unterzweiges ($C_3$, $C_7$) mit dem Gate des Verarmungsbetrieb-FET bzw. dem Gate des Anreicherungsbetrieb-FET des vierten Unterzweigs ($C_4$, $C_8$) verbunden ist, um ein zweites Unterpaar von Spaltenadressenverbindungen zu bilden, und wobei die Spaltenadressenverbindungen des ersten Unterpaares je mit den Spaltenadressenverbindungen des zweiten Unterpaares verbunden sind, um ein zweites Paar von Speicheradressenleitungen zu bilden.

3. ROM-Schaltungsanordnung nach Anspruch 1, mit einer Einrichtung (12) zum Laden eines der Schaltungsknoten auf ein erstes Potential, einer Einrichtung (G) zum Anlegen eines zweiten Potentials an den anderen Schaltungsknoten auf das Adressieren des ausgewählten Speicherelements hin, wodurch sich der eine Schaltungsknoten (10') zum zweiten Potential hin entlädt oder nicht, und zwar in Abhängigkeit von der Leitfähigkeit des von der ausgewählten Spalte gebildeten Strompfads, wobei die Ausleseeinrichtung ($T_i$, 14, 16) auf das Potential an dem einen Schaltungsknoten (10') anspricht und wobei die Einrichtung (G) zum Anlegen des zweiten Potentials schaltbar ist, um das erste Potential an den anderen Schaltungsknoten gleichzeitig mit dem Vorladen des einen Schaltungsknotens (10') anzulegen und um das zweite Potential an den anderen Schaltungsknoten anzulegen, wenn das ausgewählte Speicherelement zum Auslesen adressiert ist.

4. ROM-Schaltungsanordnung nach Anspruch 1 oder 3, wobei die Ausleseeinrichtung ($T_i$, 14, 16) einen Isoliertransistor ($T_i$) aufweist, dessen Steuerelektrode mit dem einen Schaltungsknoten (10') verbunden ist und der eine Lastschaltung (16) aufweist, die von dem einen Schaltungsknoten (10') durch den Isoliertransistor ($T_i$) getrennt ist und an der das den Bitwert repräsentierende Signal erzeugt wird.

5. ROM-Schaltungsanordnung nach Anspruch 2, mit einer Einrichtung (G), die schaltbar ist zum Anlegen des ersten Potentials an den anderen der Schaltungsknoten gleichzeitig mit dem Anlegen des ersten Potentials an den ersten Schaltungsknoten (10') und zum Anlegen des zweiten Potentials an den anderen Schaltungsknoten auf das Adressieren des ausgewählten Speicherelements hin.

6. ROM-Schaltungsanordnung nach Anspruch 3, 4 oder 5, wobei die Einrichtung (12) zum Vorladen des einen Schaltungsknotens (10') ein Schaltungselement (12) aufweist, das zwischen den einen Schaltungsknoten (10') und die schaltbare Einrichtung (G) geschaltet ist, um selektiv das erste Potential aber nicht das zweiten Potential an den einen Schaltungsknoten (10') anzulegen.

7. ROM-Schaltungsanordnung nach einem der Ansprüche 2 bis 6, wobei der eine Schaltungsknoten (10') der reste Schaltungsknoten (10') ist.

8. ROM-Schaltungsanordnung nach Anspruch 7, wobei der zweite Schaltungsknoten durch einen allen Spalten gemeinsamen Schaltungsknoten gebildet ist.

9. ROM-Schaltungsanordnung nach einem der Ansprüche 1 bis 6, wobei jeder von dem ersten (10') und von dem zweiten Schaltungsknoten durch je einen allen Spalten gemeinsamen Schaltungsknoten gebildet ist.

10. ROM-Schaltungsanordnung nach einem der vorausgehenden Ansprüche, mit einem Schalterelement (K), das in die Schaltung zwischen der Spaltenauswahleinrichtung ($C_1$—$C_{12}$) und dem ersten Schaltungsknoten (10') schaltbar ist, um als eine Seitenauswahleinrichtung für die Matrix der Speicherelemente zu wirken.

11. ROM-Schaltungsanordnung nach Anspruch 10, bei welcher das Schaltungselement (K) einen Anreicherungsbetrieb-FET aufweist.

12. ROM-Schaltungsanordnung mit:
einer ersten ($P_1$) und einer zweiten ($P_2$) Matrix aus FET-Speicherelementen ($T_1'$—$T_N'$), von denen jedes in Abhängigkeit von dem darin zu speichernden Binärbitwert von einem ersten oder einem zweiten Typ ist, wobei jede Matrix ($P_1$, $P_2$) Spalten aus in Reihe verbundenen Speicherelementen aufweist und die Spalten so miteinander verbunden sind, daß sie reihen-adressierbar sind, um ein Speicherelement zum Auslesen seines Bitwerts durch Auswahl einer Reihe und einer Spalte auszuwählen;
einer ersten Spaltenauswahleinrichtung, die zwischen die Spalten der ersten Matrix ($P_1$) und einen Schaltungsknoten (10') geschaltet ist, und eine zweite Spaltenauswahleinrichtung, die zwischen die Spalten der zweiten Matrix ($P_2$) und den ersten Schaltungsknoten (10') geschaltet ist;
einer ersten und einer zweiten Seitenauswahleinrichtung (K), die zwischen den ersten Schaltungsknoten (10') und die erste bzw. zweite Spaltenauswahleinrichtung geschaltet sind, für das Auswählen der ersten ($P_1$) oder der zweiten ($P_2$) Matrix für eine betriebsmäßige Ausleseverbindung mit dem ersten Schaltungsknoten (10');
einer Einrichtung (12) zum Vorladen des ersten Schaltungsknotens (10') auf ein erstes Potential;
einer Ausleseeinrichtung ($T_1$, 14, 16), die auf das Potential des ersten Schaltungsknotens (10') mit der Erzeugung eines Signals reagiert, das den Bitwert eines adressierten Speicherelements in einer ausgewählten der Matrizen ($P_1$, $P_2$) darstellt, wobei die Ausleseeinrichtung einen Isoliertransistor ($T_i$) aufweist, dessen Steuerelektrode mit dem ersten Schaltungsknoten (10') verbunden ist und der eine Lastschaltung (16) besitzt, die von dem ersten Schaltungsknoten (10') durch den Isoliertransistor ($T_i$) isoliert ist und an welcher das den Bitwert repräsentierende Signal erzeugt wird, wobei
die Seitenauswahleinrichtung (K) und die Spaltenauswahleinrichtung betreibbar sind, um eine Matrix auszuwählen und deren ein adressiertes Speicherelement enthaltende Spalte zwischen den ersten Schaltungsknoten (10'), der auf das erste Potential vorgeladen ist, und einen an ein zweites Potential angeschlossenen zweiten Schaltungsknoten zu schalten, wobei die Spalte einen ersten Strompfad zwischen dem ersten und dem zweiten Schaltungsknoten erzeugt, dessen Leiten von dem Typ des adressierten Speicherelements abhängt, um den ersten Schaltungsknoten (10') zum zweiten Potential hin zu entladen oder nicht, um den Bitwert des adressierten Speicherelements auszulesen,
dadurch gekennzeichnet, daß jede Spaltenauswahleinrichtung aufweist:
einen ersten ($C_9$, $C_{11}$) und einen zweiten ($C_{10}$, $C_{12}$) Schaltungszweig, die von je einer der Seitenauswahleinrichtungen (K) zu je einer Hälfte der Speicherelementspalten führen und je einen Verarmungsbetrieb-FET und einen Anreicherungsbetrieb-FET aufweisen, die in Reihe geschaltet sind, wobei das Gate des Verarmungsbetrieb-FET in jedem von dem ersten ($C_9$, $C_{11}$) und zweiten ($C_{10}$, $C_{12}$) Zweig mit dem Gate des Anreicherungsbetrieb-FET in dem zweiten ($C_{10}$, $C_{12}$) bzw. dem ersten ($C_9$, $C_{11}$) Zweig verbunden ist, um ein erstes Paar von Spaltenadressenleitungen zu bilden,
einen ersten ($C_1$, $C_5$) und einen zweiten ($C_2$, $C_6$) Schaltungsunterzweig, die vom ersten Zweig ($C_9$, $C_{11}$) zu je einem Viertel der Speicherspalten führen, und einem dritten ($C_3$, $C_7$) und einem vierten ($C_4$, $C_8$) Schaltungsunterzweig, die vom zweiten

Zweig ($C_{10}$, $C_{12}$) zu je einem Viertel der Speicherspalten führen, wobei jeder Unterzweig einen Verarmungsbetrieb-FET und einen Anreicherungsbetrieb-FET aufweist, die in Reihe geschaltet sind, und wobei das Gate des Anreicherungsbetrieb-FET und das Gate des Verarmungsbetrieb-FET des ersten Unterzweiges ($C_1$, $C_5$) mit dem Gate des Verarmungsbetrieb-FET bzw. mit dem Gate des Anreicherungsbetrieb-FET des zweiten Unterzweiges ($C_2$, $C_6$) verbunden ist, um ein erstes Unterpaar von Spaltenadressenverbindungen zu bilden, und wobei das Gate des Anreicherungsbetrieb-FET und das Gate des Verarmungsbetrieb-FET des dritten Unterzweiges ($C_3$, $C_7$) mit dem Gate des Verarmungsbetrieb-FET bzw. dem Gate des Anreicherungsbetrieb-FET des vierten Unterzweigs ($C_4$, $C_8$) verbunden ist, um ein zweites Unterpaar von Spaltenadressenverbindungen zu bilden, und wobei die Spaltenadressenverbindungen des ersten Unterpaares je mit den Spaltenadressenverbindungen des zweiten Unterpaares verbunden sind, um ein zweites Paar von Speicheradressenleitungen zu bilden.

13. ROM-Schaltungsanordnung nach Anspruch 12, wobei von der ersten und von der zweiten Seitenauswahleinrichtung (K) jede einen Anreicherungsbetrieb-FET aufweist.

14. ROM-Schaltungsanordnung nach Anspruch 12 oder 13, wobei die Enden der Spalten der ersten Matrix mit einem ersten weiteren Schaltungsknoten und die Enden der Spalten der zweiten Matrix mit einem gemeinsamen zweiten weiteren Schaltungsknoten verunden sind, und die ferner eine Einrichtung (G) aufweist, die schaltbar ist zum Anlegen des ersten Potentials an den ersten und an den zweiten weiteren Schaltungsknoten gemeinsam mit dem Vorladen des ersten Schaltungsknotens auf das erste Potential und zum Anlegen des zweiten Potentials an den ersten und an den zweiten weiteren Schaltungsknoten, wenn das ausgewählte Speicherelement in der ausgewählten Matrix zum Auslesen adressiert ist.

15. ROM-Schaltungsanordnung nach Anspruch 14, wobei die Einrichtung (12) zum Vorladen des ersten Schaltungsknotens ein Schaltungselement (12) aufweist, das zwischen den ersten Schaltungsknoten (10') und die schaltbare Einrichtung (G) geschaltet ist, um das erste, nicht jedoch das zweite Potential zum ersten Schaltungsknoten (10') zu übertragen.

## Revendications

1. Agencement de circuit de mémoire figée dans lequel des valeurs de bits binaires sont mémorisées par des éléments de mémoire à transistors à effet de champ ($T_1'$—$T_N'$) d'un premier ou second type en accord avec la valeur de bit ainsi mémorisée, les éléments de mémoire étant disposés selon une matrice adressable de rangées et de colonnes, les éléments de mémoire de chaque colonne étant connectés en série pour constituer un trajet de courant pouvant être sélectionné entre des premier (10') et second noeuds de circuit, et comportant des moyens de sélection de colonne connectés entre lesdites colonnes et ledit premier noeud de circuit (10') pour effectuer l'adressage de colonne d'un élément de mémoire adressé, la conductivité du trajet de courant à travers la colonne sélectionnée étant déterminée par le type de l'élément de mémoire adressé, et des moyens de lecture ($T_1$) sensibles à la conductivité du trajet de courant à travers la colonne sélectionné pour délivrer un signal représentant la valeur de bit de l'élément de mémoire adressé caractérisé en ce que les moyens de sélection de colonne comportent:

des première ($C_9$, $C_{11}$) et des seconde ($C_{10}$, $C_{12}$) dérivations de circuit conduisant depuis ledit premier noeud de circuit (10') jusqu'à une moitié respective des colonnes de l'élément de mémoire et chacune comportant des transistors à effet de champ du type à appauvrissement et du type à enrichissement connectés en série, la grille du transistor à effet de champ du type à appauvrissement dans chacune des première ($C_9$, $C_{11}$) et seconde ($C_{10}$, $C_{12}$) dérivations étant reliée à la grille du transistor à effet de champ du type à enrichissement dans les seconde ($C_{10}$, $C_{12}$) et première ($C_9$, $C_{11}$) dérivations respectivement pour constituer une première paire de lignes d'adresse de colonne,

des première ($C_1$, $C_5$) et seconde ($C_2$, $C_6$) sous-dérivations de circuit conduisant depuis ladite première dérivation ($C_9$, $C_{11}$) jusqu'à une quatrième des colonnes de mémoire respective et des troisième ($C_3$, $C_7$) et quatrième ($C_4$, $C_8$) sous-dérivations de circuit conduisant depuis ladite seconde dérivation ($C_{10}$—$C_{12}$) jusqu'à une quatrième des colonnes de mémoire respective, chaque sous-dérivation comportant des transistors à effet de champ du type à appauvrissement et du type à enrichissement connectés en série et dans lequel les grilles des transistors à effet de champ du type à enrichissement et du type à appauvrissement de la première sous-dérivation ($C_1$, $C_5$) sont respectivement connectées aux grilles des transistors à effet de champ du type à appauvrissement et du type à enrichissement de la seconde sous-dérivation ($C_2$, $C_6$) pour constituer une première sous-paire de connexions d'adresse de colonne, et les grilles des transistors à effet de champ du type à enrichissement et du type à appauvrissement de la troisième sous-dérivation ($C_3$, $C_7$) sont respectivement connectées aux grilles des transistors à effet de champ du type à appauvrissement et du type à enrichissement de la quatrième sous-dérivation ($C_4$, $C_8$) pour constituer une seconde sous-paire de connexions d'adresse de colonne, et dans lequel les connexions d'adresse de colonne de la première sous-paire sont connectées à des connexions d'adresse de colonne respective de la seconde sous-paire pour constituer une seconde paire de lignes d'adresse de colonne.

2. Agencement de circuit de mémoire figée dans lequel des valeurs de bits binaires sont mémorisées par des éléments de mémoire ($T_1'$—$T_N'$) d'un premier ou second type en accord avec la valeur de bit ainsi mémorisée, les éléments de mémoire étant disposés en une matrice adressable, la matrice possédant des colonnes d'éléments de mémoire connectés en série, les colonnes étant interconnectées pour être adressables par rangées pour sélectionner un élément de mémoire pour une lecture de sa valeur de bit par sélection d'une rangée et d'une colonne, et comportant des moyens de sélection de colonne connectés entre lesdites colonnes et un premier noeud de circuit (10') pour sélectionner une colonne pour établir un trajet de courant entre ledit premier noeud de circuit et un second noeud de circuit, trajet dont la conductivité dépend du type de l'élément de mémoire à transistor à effet de champ dans la colonne sélectionnée par adressage de rangée, des moyens (12) pour charger préalablement l'un (10') desdits noeuds de circuit à un premier potentiel de telle sorte que, lors de la sélection de rangée et de colonne d'un élément de mémoire en vue d'une lecture de sa valeur de bit, ledit premier noeud de circuit (10') se décharge ou non vers un second potentiel appliqué à l'autre noeud de circuit en fonction du type du transistor à effet de champ constituant l'élément de mémoire sélectionné, et des moyens de lecture ($T_I$, 14, 16) sensibles au potentiel résultant dudit premier noeud de circuit pour délivrer un signal représentant la valeur de bit de l'élément de mémoire sélectionné, lesdits moyens de lecture comprenant un transistor d'isolement ($T_I$) ayant son électrode de commande connectée audit premier noeud de circuit (10') et ayant un circuit de charge (16) qui est isolé dudit premier noeud de circuit (10') par le transistor d'isolement ($T_I$) et auquel ledit signal représentant la valeur de bit est généré, caractérisé en ce que les moyens de sélection de colonne comportent:

des première ($C_9$, $C_{11}$) et des seconde ($C_{10}$, $C_{12}$) dérivations de circuit conduisant depuis ledit premier noeud de circuit (10') jusqu'à une moitié respective des colonnes de l'élément de mémoire et chacune comportant des transistors à effet de champ du type à appauvrissement et du type à enrichissement connectés en série, la grille du transistor à effet de champ du type à appauvrissement dans chacune des première ($C_9$, $C_{11}$) et seconde ($C_{10}$, $C_{12}$) dérivations étant reliée à la grille du transistor à effet de champ du type à enrichissement dans la seconde ($C_{10}$, $C_{12}$) et première ($C_9$, $C_{11}$) dérivations respectivement pour constituer une première paire de lignes d'adresse de colonne,

des première ($C_1$, $C_5$) et des seconde ($C_2$, $C_6$) sous-dérivations de circuit conduisant depuis ladite première dérivation ($C_9$, $C_{11}$) à une quatrième respective des colonnes de mémoire et des troisième ($C_3$, $C_7$) et quatrième ($C_4$, $C_8$) sous-dérivations de circuit conduisant depuis ladite seconde dérivation ($C_{10}$—$C_{12}$) à une quatrième respective des colonnes de mémoire, chaque sous-dérivation comportant des transistors à effet de champ du type à appauvrissement et du type à enrichissement connectés en série, et dans laquelle les grilles des transistors à effet de champ du type à enrichissement et du type à appauvrissement de la première sous-dérivation ($C_1$, $C_5$) sont respectivement reliées aux grilles des transistors à effet de champ du type à appauvrissement et du type à enrichissement de la seconde dérivation ($C_2$, $C_6$) pour constituer une première sous-paire de connexions d'adresse de colonne, et les grilles des transistors à effet du champ du type à enrichissement et du type à appauvrissement de la troisème sous-dérivation ($C_3$, $C_7$) sont respectivement reliées aux grilles des transistors à effet de champ du type à appauvrissement et du type à enrichissement de la quatrième sous-dérivation ($C_4$, $C_8$) pour constituer une seconde sous-paire de connexions d'adresse de colonne, et dans laquelle les connexions d'adresse de colonne de la première sous-paire sont reliées aux connexions d'adresse de colonne respectives de la seconde sous-paire pour constituer une seconde paire de lignes d'adresse de colonne.

3. Agencement de circuit de mémoire figée selon la revendication 1, comportant des moyens (12) pour charger un desdits noeuds de circuit à un premier potentiel, des moyens (G) pour appliquer un seconde potentiel à l'autre noeud de circuit lors de l'adressage de l'élément de mémoire sélectionné de telle sorte que ledit premier noeud de circuit (10') se décharge ou non vers ledit second potentiel selon la conductivité du trajet de courant constitué par la colonne sélectionnée, lesdits moyens de lecture ($T_I$, 14, 16) étant sensibles au potentiel sur ledit premier noeud (10') et dans lequel lesdits moyens (G) pour appliquer ledit premier potentiel audit autre noeud de circuit simultanément avec la charge préalable dudit premier noeud de circuit (10') et pour appliquer ledit second potentiel audit autre noeud de circuit lorsque l'élément de mémoire sélectionné est adressé pour une lecture.

4. Agencement de circuit de mémoire figée selon la revendication 1 ou 3, dans lequel lesdits moyens de lecture ($T_I$, 14, 16) comprennent un transistor d'isolement ($T_I$) ayant son électrode de commande reliée audit premier noeud de circuit (10') et ayant un circuit de charge (16) qui est isolé dudit premier noeud de circuit (10') par ledit transistor d'isolement ($T_I$) et auquel ledit signal représentant la valeur de bit est généré.

5. Agencement de circuit de mémoire figée selon la revendication 2, comprenant des moyens (G) commutables, pour appliquer ledit premier potentiel à l'autre desdits noeuds de circuit simultanément avec l'application dudit premier potentiel audit premier noeud de circuit (10') et pour appliquer ledit second potentiel audit autre noeud de circuit lors de l'adressage de l'élément de mémoire sélectionné.

6. Agencement de circuit de mémoire figée selon la revendication 3, 4 ou 5, dans lequel lesdits moyens (12) pour charger préalablement ledit premier noeud de circuit (10) comprennent un élément de circuit (12) connecté entre ledit premier noeud de circuit (10') et lesdits moyens commutables (G) pour transmettre sélectivement ledit premier potentiel mais non ledit second potentiel audit premier noeud de circuit (10').

7. Agencement de circuit de mémoire figée selon l'une quelconque des revendications 2 à 6, dans lequel ledit noeud de circuit (10') est ledit premier noeud de circuit (10').

8. Agencement de circuit de mémoire figée selon la revendication 7, dans lequel ledit second noeud de circuit est constitué par un noeud de circuit commun à toutes les colonnes.

9. Agencement de circuit de mémoire figée selon l'une quelconque des revendications 1 à 6, dans lequel chacun desdits premier (10') et second noeuds de circuit est constitué par un noeud de circuit respectif commun à toutes les colonnes.

10. Agencement de circuit de mémoire figée selon l'une quelconque de revendications précédentes, comportant un élément de commutation (K) pouvant être monté en circuit entre lesdits moyens de sélection de colonne (C₁—C₁₂) et ledit premier noeud de circuit (10') pour agir en tant que moyens de sélection de page pour ladite matrice d'éléments de mémoire.

11. Agencement de circuit de mémoire figée selon la revendication 10, dans lequel ledit élément de commutation (K) comporte un transistor à effet de champ du type à enrichissement.

12. Agencement de circuit de mémoire figée comportant:

des première ($P_1$) et seconde ($P_2$) matrices d'éléments de mémoire à transistors à effet de champ ($T_1'$—$T_N'$), chaque élément étant d'un premier ou d'un second type selon la valeur de bit binaire ainsi mémorisée, chaque matrice ($P_1$, $P_2$) possédant des colonnes d'éléments de mémoire connectés en série, les colonnes étant interconnectées pour être adressables par rangée pour sélectionner un élément de mémoire pour une lecture de sa valeur de bit par sélection de rangée et de colonne;

des premiers moyens de sélection de colonne connectés entre les colonnes de la première matrice ($P_1$) et un premier noeud de circuit (10') et des seconds moyens de sélection de colonne connectés entre les colonnes de la seconde matrice ($P_2$) et ledit premier noeud de circuit (10'),

des premier et second moyens de sélection de page (K) montés entre ledit premier noeud de circuit (10') et respectivement lesdits premier et second moyens de sélection de colonne pour sélectionner ladite première ($P_1$) ou seconde ($P_2$) matrice pour une connexion de lecture fonctionnelle avec ledit premier noeud de circuit (10');

des moyens (12) pour charger préalablement ledit premier noeud de circuit (10') à un premier potentiel;

des moyens de lecture ($T_i$, 14, 16) sensibles au potentiel sur ledit premier noeud de circuit (10') pour délivrer un signal représentant la valeur de bit d'un élément de mémoire adressé dans l'une sélectionnée desdites matrices ($P_1$, $P_2$), lesdits moyens de lecture comprenant un transistor d'isolement ($T_i$) ayant son électrode de commande reliée audit premier noeud de circuit (10') et possédant un circuit de charge (16) qui est isolé dudit premier noeud de circuit (10') par le transis-

tor d'isolement ($T_i$) et auquel est généré ledit signal représentant la valeur de bit, dans lequel

lesdits moyens de sélection de page (K) et les moyens de sélection de colonne sont actionnables pour sélectionner une matrice et connecter la colonne de celle-ci contenant un élément de mémoire adressé entre ledit premier noeud de circuit (10') préalablement chargé audit premier potentiel et un second noeud de circuit connecté à un second potentiel, la colonne assurant un trajet de courant entre les premier et second noeuds de circuit dont la conduction dépend du type de l'élément de mémoire adressé pour décharger ou non ledit premier noeud de circuit (10') vers ledit second potentiel pour une lecture de la valeur de bit de l'élément de circuit adressé, et caractérisé en ce que:

chacun des moyens de sélection de colonne comporte:

des première ($C_9$, $C_{11}$) et seconde ($C_{10}$, $C_{12}$) dérivations de circuit conduisant des moyens de sélection de page respectifs (K) à une moitié respective des colonnes d'éléments de mémoire et comprenant chacune des transistors à effet de champ du type à appauvrissement et du type à enrichissement connectés en série, la grille du transistor à effet de champ du type à appauvrissement dans chacune des première ($C_9$, $C_{11}$) et seconde ($C_{10}$, $C_{12}$) dérivations étant connectée à la grille du transistor à effet de champ du type à enrichissement dans les seconde ($C_{10}$, $C_{12}$) et première ($C_9$, $C_{11}$) dérivations respectivement pour constituer une première paire de lignes d'adresse de colonne,

des première ($C_1$, $C_5$) et seconde ($C_2$, $C_6$) sous-dérivations de circuit conduisant depuis ladite première dérivation ($C_9$, $C_{11}$) à une quatrième respective des colonnes de mémoire et des troisième ($C_3$, $C_7$) et quatrième ($C_4$, $C_8$) sous-dérivations de circuit conduisant depuis ladite seconde dérivation ($C_{10}$, $C_{12}$) à une quatrième respective des colonnes de mémoire, chaque sous-dérivation comportant des transistors à effet de champ du type à appauvrissement et du type à enrichissement connectés en série et dans lequel les grilles des transistors à effet de champ du type à enrichissement et du type à appauvrissement de la première sous-dérivation ($C_1$, $C_5$) sont respectivement connectées aux grilles des transistors à effet de champ du type à appauvrissement et du type à enrichissement de la seconde sous-dérivation ($C_2$, $C_6$) pour constituer une première sous-paire de connexions d'adresse de colonne, et les grilles des transistors à effet de champ du type à enrichissement et du type à appauvrissement de la troisième sous-dérivation ($C_3$, $C_7$) sont respectivement connectées aux grilles des transistors à effet du champ du type à appauvrissement et du type à enrichissement de la quatrième sous-dérivation ($C_4$, $C_8$) pour constituer une seconde sous-paire de connexions d'adresse de colonne, et dans lequel les connexions d'adresse de colonne de la première sous-paire sont connectées à des connexions d'adresse de colonne respectives de la seconde sous-paire pour constituer une seconde paire de ligne d'adresse de colonne.

13. Agencement de circuit de mémoire figée selon la revendication 12, dans lequel chacun desdits premier et second moyens de sélection de page (K) comporte un transistor à effet de champ du type à enrichissement.

14. Agencement de circuit de mémoire figée selon la revendication 12 ou 13, dans lequel les extrémités des colonnes de la première matrice sont connectées à un premier autre noeud de circuit commun et les extrémités des colonnes de la seconde matrice sont connectées à un second autre noeud de circuit commun, et comportant en outre des moyens (G) commutables pour appliquer ledit premier potentiel auxdits premier et second autres noeuds de circuit simultanément avec la charge préalable du premier noeud de circuit audit premier potentiel et pour appliquer ledit second potentiel auxdits premier et second autres noeuds de circuit lorsque l'élément de mémoire sélectionné dans la mémoire choisie est adressé pour une lecture.

15. Agencement de circuit de mémoire figée selon la revendication 14, dans lequel lesdits moyens (12) pour charger préalablement ledit premier noeud de circuit comportent un élément de circuit (12) monté entre ledit premier noeud de circuit (10') et lesdits moyens commutables (G) pour transmettre ledit premier mais non ledit second potentiel audit premier noeud de circuit (10').

# FIG.1 PRIOR ART

# FIG.2

EP 0 095 847 B1

# FIG.3

FIG. 4

EP 0 095 847 B1

FIG. 5

4